# EUROPÄISCHE PATENTANMELDUNG

(11) **EP 4 220 965 A1**
(43) Veröffentlichungstag der Anmeldung: **02.08.2023**
(21) Anmeldenummer: 22153424.1
(22) Anmeldetag: 26.01.2022
(51) Int. Cl.: H03M 7/30, G05B 13/04, G05B 19/418

(54) **VERFAHREN ZUR DATENKOMPRESSION VON MESSDATEN, PRODUKT, COMPUTERPROGRAMMPRODUKT, FERTIGUNGSVERFAHREN**

(71) Anmelder: Siemens Aktiengesellschaft, 80333 München (DE)
(72) Erfinder: Hofmann, Ingmar Patrick, 90537 Feucht (DE); Krüger, Daniel, 91154 Roth (DE); Schenk, Bernhard, 90537 Feucht (DE)
(74) Vertreter: Siemens Patent Attorneys

(57) **Zusammenfassung**

Die Erfindung betrifft ein Verfahren zur Datenkompression von Messdaten (MDT) umfassend die folgenden Schritte,
(a) Messen von Prozessdaten (PCD) eines Prozesses (PRC),
(b) computer-implementiertes Verarbeiten der Prozessdaten (PCD) zu Archivdaten (ADT).
Daneben betriff die Erfindung auch ein entsprechendes Produkt, Computerprogrammprodukt und ein Fertigungsverfahren zur Erstellung des Produkts. Zur Reduktion des Speicherbedarfs bei der Archivierung wird vorgeschlagen, dass Schritt (b) die folgenden weiteren Schritte umfasst und die Archivdaten (ADT) die Produkte dieser Schritte umfassen:
(b1) Bereitstellen eines computer-implementierten Modells (MDL), dass die zu messenden Prozessdaten (PCD) als synthetische Prozessdaten (SPD) erzeugt,
(b2) computer-implementiertes Bestimmen von Differenzdaten (DDT) als eine Differenz zwischen den gemessenen Prozessdaten (PCD) und den synthetischen Prozessdaten (SPD),
(b3) Erzeugen einer Zuordnung (CCD) des Modells (MDL), der Differenzdaten (DDT) und dem Prozess (PRC) jeweils zueinander.

## Beschreibung

Die Erfindung betrifft ein Verfahren zur Datenkompression von Messdaten umfassend die folgenden Schritte,
(a) Messen von Prozessdaten eines Prozesses,
(b) computer-implementiertes Verarbeiten der Prozessdaten zu Archivdaten.

Daneben betriff die Erfindung auch ein entsprechendes Computerprogrammprodukt und ein Fertigungsverfahren zur Erstellung eines Produkts unter Aufzeichnung und Komprimierung von Prozessdaten des Fertigungsprozesses sowie das Produkt umfassend die komprimierten Prozessdaten.

Die Erfindung beschäftigt sich mit der Komprimierung von gemessenen Prozessdaten, insbesondere aus der Überwachung von Fertigungsprozessen, insbesondere zur Qualitätssicherung der gefertigten Bauteile. Diese Überwachung kann je nach Verfahren und Sensorik große Mengen an Prozess- und Messdaten erzeugen. Die Erfindung bezeichnet diese Daten zusammenfassend als Prozessdaten. Insbesondere im Zusammenhang mit Fertigungsprozessen können die Prozessdaten auch als Überwachungsdaten bezeichnet werden.

Insbesondere bei additiven Fertigungsprozessen wie SLM (https://de.wikipedia.org/wiki/Selektives_Laserschmelzen) entstehen Prozessdaten in der Größenordnung von Giga- bis Terabytes pro gefertigten Bauteil - beispielsweise bei der Überwachung eines auftragenden Laserschmelzprozesses durch optische Tomographie (https://de.wikipedia.org/wiki/Optische_Kohärenztomografie). Das Sichern, Kopieren und Transferieren dieser Prozessdaten ist zeitaufwändig und verursacht Kosten und Logistikprobleme, z.B. durch die notwendige redundante Sicherung auf lokalen Festplatten oder durch eine Datensynchronisation mit einem Cloud-Speicher.

Bei der industriellen additiven Fertigung werden vorzugsweise hochpreisige individualisierte Bauteile für Spezialanwendungen hergestellt. Bei dieser Anwendung müssen Prozessdaten oft für jedes einzelne gefertigte Bauteil aufbewahrt werden. Diese Aufbewahrungspflicht gibt es beispielsweise bei der Produktion sicherheitskritischer Bauteile im Aerospace- oder Energiesektor (z.B. zur Absicherung gegen Regressansprüche beim Versagen eines Bauteils).

Ein Problem betreffend die Datenweiterleitung und Datenaggregation bei großen Rohdatenmengen ist deren Handhabung auf ressourcenbeschränkten Geräten wie z.B. einer SINUMERIK Edge (https://new.siemens.com/global/de/produkte/automatisierung/themenfelder/industrial-edge/sinumerik-edge.html). Dieses Gerät kann Messdaten im Maschinennetz zwar schnell und unmittelbar sammeln, diese Daten aber nur langsam und nicht immer sofort an eine verbundene Cloud (z.B. Mindsphere, https://siemens.mindsphere.io/de) weiterleiten. Das liegt daran, dass die Bandbreite der Datenweitergabe zwischen Edge-Anwendung und Cloud-Anwendung konzeptionell gedrosselt wird (u.a. aus Sicherheitsabwägungen). Es kann dadurch zur Datenaggregation kommen derart, dass ein Edge-Gerät große Datenmengen lokal schneller aufnimmt als es diese wieder in die Cloud abgibt. Ist die Cloud-Anbindung zu langsam oder fällt der Cloud-Provider für eine Weile aus, kann es auf dem Edge-Gerät zum Überlauf mit Datenverlust kommen.

Erschwerend kommt hinzu, dass sich Prozessdaten mit den gängigen Komprimierungsverfahren (z.B. Lempel-Ziv-Varianten, https://go-compression.github.io/algorithms/lz/) der Büro-IT in der Regel nicht gut komprimieren lassen, da Messdaten aus dem Bereich der additiven Fertigung eine hohe Informationsentropie aufweisen und auf die meisten Komprimierungsverfahren wie (nicht komprimierbare) Zufallszahlen wirken.

Zum Überwachen von Fertigungsprozessen werden entweder proprietäre Lösungen der Maschinenhersteller eingesetzt (die Daten oft lokal auf der Produktionsmaschine sammeln) oder industrielle Prozessüberwachungssysteme.

Systeme zum Aufnehmen und Sichern von Messwerten und ausgewählten Steuerungssignalen sind beispielsweise:
- SPS bzw. Speicherprogrammierbare Steuerung (https://de.wikipedia.org/wiki/Speicherprogrammierbare_Steuerung)-,
- SIMATIC HMI (https://new.siemens.com/global/de/produkte/automatisierung/simatichmi/panels.html)-,
- NCU bzw. Numerical Control Unit- oder
- PC bzw. Mehrzweckcomputer-gestützte Systeme,
wobei Mischformen aus diesen Systemen üblich sind. Weitere Systeme zum Aufnehmen und Sichern von Messwerten sind:
- SPS-basierte Datenlogger. Diese verwalten in der Regel kleinere Datenmengen weniger Sensoren, die oft zur direkten Ansicht und Beurteilung durch den Maschinenbediener auf lokalen HMIs wie Operator Panels gesammelt werden.
- NCU-basierte Systeme zeichnen größere Datenmengen insbesondere mit Bezug zur Bewegungsführung einer Maschine auf (Bahndaten, Motorströme, Vorschubkräfte usw.) und stellen diese üblicherweise wiederum lokal auf dem Maschinen-HMI dar.
- (Industrie-) PC-basierte Systeme verarbeiten in der Regel die größten Datenmengen und aggregieren vorverarbeitete Daten von SPSen, HMIs, NCUs, dezentraler Peripherie, Antrieben usw. ("Flugdatenschreiber"-Funktion) oder sammeln Datenströme netzwerkfähiger Industriesensoren (z.B. Thermokameras, Laserscannern, Ultraschallsensoren usw.).

Zu diesen traditionellen Systemen kommen in jüngster Zeit noch Edge- und Cloud-basierte Systeme hinzu, die eine Brücke zwischen Fertigungs- und IT-Welt schlagen, so dass Anwender aktuelle und historische Maschinendaten ortsunabhängig einsehen und auswerten können. Die meisten der genannten Systeme sammeln und cachen (= zumindest zwischenzeitliches Abspeichern in einem Pufferspeicher) anfallende Daten lokal, wo diese oft schon nach kurzer Zeit wieder vernichtet werden, beispielsweise bei Produktionsbeginn des nächsten Bauteils. Das macht eine spätere Nutzung der Prozessdaten unmöglich. Produktionssysteme mit Dokumentationspflicht speichern Datensammlungen auf (Wechsel-) Festplatten bzw. Festplattenarrays direkt in der Produktionsmaschine, am Produktionsstandort oder in Rechenzentren.

Aus dem Stand der Technik ist bereits zur generellen Komprimierung von Daten bekannt eine Deltakomprimierung durchzuführen. Weitere Einzelheiten hierzu finden sich unter:
- https://de.wikipedia.org/wiki/Delta-Kodierung
- https://en.wikipedia.org/wiki/Delta_encoding
- https://en.wikipedia.org/wiki/Data_compression
- https://en.wikipedia.org/wiki/Data_differencing.

Ausgehend von den Problemen und Nachteilen des Standes der Technik hat es sich die Erfindung zur Aufgabe gemacht, das Verfahren eingangs definierter Art derart weiterzubilden, sodass die erläuterten Probleme und Nachteile vermieden werden.

Zur erfindungsgemäßen Lösung der Aufgabe wird ein Verfahren oder ein System eingangs definierter Art mit den zusätzlichen Merkmalen des Kennzeichens des unabhängigen Anspruchs 1 vorgeschlagen.

Daneben schlägt die Erfindung ein entsprechendes Computerprogrammprodukt vor. Die jeweils abhängigen Unteransprüche beinhalten vorteilhafte Weiterbildungen der Erfindung.

Das Bereitstellen eines computer-implementierten Modells nach der Erfindung kann in einer vorteilhaften Weiterbildung als eine Simulation zum Beispiel eines Fertigungsprozesses erfolgen. Dieser Fertigungsprozess, oder genauer die im Fertigungsprozess erwarteten relevanten, mittels Sensoren gemessenen Prozessdaten, werden mittels eines Modells - einer Prozesssimulation - erzeugt bzw. simuliert. Diese Simulation kann entweder in Echtzeit parallel zum Produktionsprozess (bevorzugt), aber auch der Produktion vor- oder nachgelagert erfolgen.

Eine vorteilhafte Weiterbildung der Erfindung sieht vor, dass es sich um ein deterministisches Modell oder eine deterministische Simulation handelt. Diese Prozesssimulation sollte bevorzugt vollständig deterministisch sein. Aus diesem Determinismus ergibt sich, dass der Simulationsalgorithmus bei gleichen (Start-) Parametern über die Zeit immer die gleichen Simulationswerte erzeugt.

Die Archivdaten umfassen die Zuordnung des Modells, der Differenzdaten und des Prozesses jeweils zueinander. Hierbei kann eine eindeutige Spezifikation bzw. ein eindeutiger Verweis auf das Modell genügen oder es kann das komplette Modell als Bestandteil der Archivdaten behandelt werden. Das Modell kann im Falle des Verweises an einem anderen Ort hinterlegt sein als die Archivdaten selbst. Der Prozess selbst kann mit einer Kennung versehen oder benannt sein und auf diese Weise in der Zuordnung identifizierbar sein. Dieser Kennung können zusätzliche Informationen in den Archivdaten angegliedert sein oder diese zusätzlichen Informationen können anderswo abgelegt sein.

Nach der Erfindung werden vorteilhaft die Differenzdaten gebildet aus
den gemessenen Prozessdaten und den synthetischen Prozessdaten oder
einer auf den gemessenen Prozessdaten basierenden Größe und einer entsprechenden Größe basierend auf den synthetischen Prozessdaten (SPD). Die Differenzbildung erfolgt also immer mit sich entsprechenden Größen, derart, dass die synthetischen Daten und die auf Messung basierenden Daten sich physikalisch entsprechen oder im Wesentlichen Produkte der gleichen Umformungen sind.

In der Begriffswelt dieser Erfindung bedeutet "hashen" eine Zuordnung eines Ausgabewertes einer Hashfunktion oder Streuwertfunktion zu dem "gehashten" Objekt. Eine entsprechende Hashfunktion ist eine Abbildung, die eine große Eingabemenge, - in der Regel das Objekt selbst, auf eine kleinere Zielmenge, die Hashwerte, abbildet - siehe auch unter: https://de.wikipedia.org/wiki/Hashfunktion#Prüfsummen.

Eine vorteilhafte Weiterbildung sieht vor, dass das benutzte Modell - also beispielsweise die Prozesssimulation bzw. der Simulationsalgorithmus - eindeutig identifizierbar gekennzeichnet ist. Der besondere Vorteil in dieser Eindeutigkeit liegt darin, dass zum späteren Wiederherstellen von Prozessdaten sichergestellt wird, dass das gleiche Modell verwendet wird. Besonders bevorzugt wird dazu das Modell bzw. der Simulationsalgorithmus mit einem eindeutigen dauerhaften Identifiziermerkmal

PID (https://de.wikipedia.org/wiki/Persistent_Identifier) versehen und bevorzugt versioniert auf einem sicheren Speicher (z.B. in der Cloud) abgelegt und bevorzugt zusätzlich gehasht bzw. digital signiert. Diese Maßnahmen stellen sicher, dass ältere Modelle oder Simulationsalgorithmen auch nach Jahren noch eindeutig identifizierbar bleiben.

Eine vorteilhafte Weiterbildung sieht vor, dass der binäre Simulationscode in einem plattformunabhängigen Befehlssatz einer Pseudo-Maschine - also einem sogenanten p-Code (https://de.wikipedia.org/wiki/P-Code) gespeichert wird, um zum Beispiel hardwareabhängige Variationen (z.B. durch eine prozessorspezifische Handhabung von Gleitkommazahlen, https://de.wikipedia.org/wiki/Gleitkommazahl#Versteckte_Verwendung_anderer_Darstellungen) im Output der Simulation zu vermeiden und eindeutig reproduzierbare Simulationsergebnisse zu erhalten.

Die computer-implementiertes Bestimmung von Differenzdaten als eine Differenz zwischen einer auf den gemessenen Prozessdaten basierenden Größe und einer entsprechenden Größe basierend auf den synthetischen Prozessdaten kann als direkte Differenzbildung der gemessenen Prozessgröße und der synthetischen Prozessgröße erfolgen. Alternativ kann diese Differenzbildung vollzogen werden im Anschluss an eine Umformung, zum Beispiel eine Umrechnung und/oder rechnerische Kombination verschiedener Prozessdaten miteinander. Diese Umformung kann in dem Modell zur Erzeugung der synthetischen Prozessdaten identisch bzw. symmetrisch mit der Umformung an den gemessenen Prozessdaten erfolgen oder nicht bzw. asymmetrisch. Ein Beispiel für eine Möglichkeit einer asymmetrischen Umformung nur der gemessenen Prozessdaten liegt in einer Filterung oder Glättung der gemessenen Prozessdaten, insbesondere, um ein Rauschen in den Messdaten zu beseitigen (siehe unten). In diesem Zusammenhang bedeutet eine Entsprechung im Sinne von "einer entsprechenden Größe basierend auf den synthetischen Prozessdaten", dass die Größe, zumindest im Wesentlichen, die gleiche physikalische Bedeutung hat, wobei zum Beispiel eine Filterung von Messdaten zwar zum Ziel hat, störende Faktoren der Messung (z.B. Rauschen) zu beseitigen aber nicht die physikalische Bedeutung der Messgröße grundlegend zu verändern. Grundsätzlich kann das Modell auch das Messprinzip der Messung der gemessenen Prozessdaten zur Erzeugung der synthetischen Prozessdaten nachbilden. Diese Nachbildung kann auch eine Veränderung der Prozessdaten umfassen, in der Art einer Kombination von Messdaten oder eine andere Veränderung, wie zum Beispiel eine Filterung, insbesondere, um ein Rauschen zu unterdrücken.

In einer alternativen Ausprägung einer Weiterbildung der Erfindung wird der Simulationscode zusammen mit jedem größeren Block von Prozessdaten gesichert. Das verringert die Effizienz der Datenreduktion, erlaubt im Gegenzug aber die Wiederherstellung der Prozessdaten ohne Zugriff auf einen (externen) Ablageort mit dem Simulationsalgorithmus. In anderen Worten, kann vorgesehen sein, dass das Modell zusammen mit vorbestimmten Datenmengen von Differenzdaten als Archivdaten gemeinsam gesichert wird. Die vorbestimmte Datenmenge kann in festen Datenmengenblöcken vorgegeben sein (z.B. 5TB pro vorbestimmte Datenmenge) oder auch in einer Anzahl von Prozessen.

Eine besonders bevorzugte Weiterbildung der Erfindung sieht vor, dass Parameter des Modells oder Simulationsparameter eindeutig identifizierbar gesichert werden.

Beispielsweise werden die Simulationsparameter der simulierten Werkstückfertigung gesichert und - je nach Anforderung der Überwachungsaufgabe - noch gehasht oder gehasht und signiert.

Ein wichtiger Aspekt der Erfindung liegt in dem Bestimmen der Abweichung zwischen Modell und Prozess bzw. Simulation und Realität. Diese Art der Datenkompression kann als eine besondere Form oder Abwandlung der Deltakompression betrachtet werden. Das Modell, bzw. die Simulation, berechnet die bevorzugt zeitgestempelten erwarteten Überwachungsdaten bzw. synthetisierten zeitabhängigen Prozessdaten. Diese können - zum Beispiel während oder nach der Fertigung - mit den physischen bzw. tatsächlichen von der Maschinensensorik ermittelten Prozessdaten verglichen werden. Anschließend wird die Differenz zwischen den synthetischen Prozessdaten und diesen tatsächlichen Messdaten - also zwischen der Simulation und Realität - gebildet.

Anstelle aller Prozessdaten werden dementsprechend nur die ermittelten Abweichungen zwischen simulierten und physischen Werten gesichert, um später mit dem (eindeutig identifizierbar gesicherten) Simulationsalgorithmus wiederhergestellt werden zu können.

Je besser die Prozesssimulation ist, und je genauer das gefertigte Werkstück dem in der Simulation erwarteten Ergebnis entspricht, umso geringer fällt diese Abweichung aus und in Folge auch die zu sichernde Datenmenge. Dementsprechend ermöglicht die erfindungsgemäße Datenkomprimierung mittels einer Differenz zu einer Prozesssimulation eine lokale Reduktion der Informationsentropie (https://de.wikipedia.org/wiki/Entropie_(Informationstheorie)) durch das Entfernen berechenbarer Anteile aus den physischen Prozessdaten.

Einige der folgenden vorteilhaften bevorzugten Ausprägungen der Erfindung beschäftigen sich mit dem in der Praxis häufig vorkommen Fall, dass den Messungen ein Rauschen überlagert ist, d.h. das Nutzsignal ist immer mit einem nicht-berechenbaren Störanteil beaufschlagt. Dieser Anteil entsteht durch Phänomene wie das thermische Rauschen der eingesetzten Halbleitersensoren, oder durch von außen ins zu messende System (und das Messystem) eingetragene mechanische oder elektromagnetische Fremdschwingungen. Je größer der Störanteil in den Prozessdaten und je ungenauer die Simulation ist, desto geringer ist die erzielbare Datenkompression in der Realität. Die folgenden Weiterbildungen der Erfindung erläutern Strategien, um dem entgegenzuwirken.

Die Erfindung sieht vor, dass eine Differenzdatenbildung erfolgt, indem zum Beispiel die simulierten bzw. synthetischen Prozessdaten von den physisch gemessenen Prozessdaten abgezogen werden. Dieses Vorgehen basiert auf der Erkenntnis, dass bei einer guten Passung der Simulation (in anderen Worten: gute Übereinstimmung des Modells mit dem Prozess) der Dynamikumfang (https://de.wikipedia.org/wiki/Dynamikumfang) des Differenzsignals deutlich kleiner ist als der Dynamikumfang der simulierten bzw. gemessenen Prozessdaten. Der auf diese Weise verkleinerte Wertebereich der Differenzdaten kann daher mit einer kleineren Amplitudenauflösung bzw. Samplingtiefe (https://de.wikipedia.org/wiki/Samplingtiefe) codiert werden (z.B. nur noch mit 10 anstelle von 24 bit pro Sample), wodurch weniger Speicherplatz verbraucht wird.

Voraussetzung für die Anwendbarkeit dieser Ausprägung der Erfindung ist eine verlässliche Fehlerabschätzung bzw. Abschätzung über die Genauigkeit der Simulation (also die maximal zu erwartende Abweichung) sowie eine Kenntnis über die minimal erforderliche Amplitudenauflösung (Samplingtiefe) der Werte. Konkret sieht eine vorteilhafte Weiterbildung der Erfindung vor, dass die Samplingtiefe festlegt wird mittels der Schritte:
- Fehler-Abschätzen einer maximal zu erwartenden Abweichung zwischen synthetischen Prozessdaten und gemessenen Prozessdaten als Fehlerabschätzung,
- Festlegen einer Fehleramplitude als Produkt eines Sicherheitsfaktors mit der Fehlerabschätzung.
- Festlegen der Samplingtiefe anhand eines Quotients aus der Fehleramplitude und einer zuvor festgelegten Amplitudenauflösung.

Hierbei bedeutet die Samplingtiefe, auch Bittiefe genannt, die Anzahl der Bits, die bei der Quantisierung des analogen Messwerts pro Abtastwert (=Sample) verwendet werden.

Eine andere Möglichkeit einer vorteilhaften Weiterbildung sieht ein Glätten der Differenzdaten oder bevorzugt der gemessenen Prozessdaten vor der Kompression vor. Diese Methode ist verlustbehaftet. Hierbei werden bevorzugt die gemessenen Prozessdaten vor der Kompression geglättet - beispielsweise durch:
- bevorzugt anwendungsspezifisch parametrierte Bandpassfilter (https://de.wikipedia.org/wiki/Bandpass) zur Unterdrückung von Störungen in bestimmten Frequenzbereichen (dies funktioniert gut, wenn das für eine Anwendung relevante Frequenzband bekannt ist oder Störungen hauptsächlich in einem anderen Band auftreten) oder
- eine Mittelwertbildung (unter Inkaufnahme des Verlustes an zeitlicher Auflösung), siehe https://de.wikipedia.org/wiki/Gleitender_Mittelwert.

Eine andere Möglichkeit einer vorteilhaften Weiterbildung sieht ein Aufteilen der Abweichungen in relevante und irrelevante Abweichungen gegenüber der Simulation vor. Diese Methode ist verlustbehaftet. Als relevant erkannte Abweichungen werden der Archivierung bzw. Differenzbildung (Schritt (b2): computer-implementiertes Bestimmen von Differenzdaten als eine Differenz zwischen den gemessenen Prozessdaten und den synthetischen Prozessdaten) unterzogen. Abweichungen, die nicht als relevant erachtet werden, werden vernachlässigt (zu Null gesetzt). Die Relevanz der Abweichung kann mittels eines Grenzwertes für den Betrag der Abweichung festgelegt sein, so dass bei Abweichungen unterhalb dieses Grenzwertes die Abweichung vernachlässigt wird und damit nur Abweichungen oberhalb des Grenzwertes Speicherplatz beanspruchen.

Eine weitere Möglichkeit einer vorteilhaften Weiterbildung der Erfindung sieht einen Vergleich zwischen simulierten und physisch ermittelten Prozessdaten vor, um Abweichungen eines vorgegebenen Maßes zwischen Simulation und Fertigung zu finden. In dieser Ausprägung werden physisch ermittelten Werte nur dann gespeichert, wenn die Abweichung zu den erwarteten Werten zu groß wird - zum Beispiel ein real gefertigtes Werkstück also "erheblich" vom vorausgeplanten abweicht.

Bei der späteren Rekonstruktion der Prozessdaten werden also im Idealfall keine physisch gemessenen, sondern nur die simulierten Daten angezeigt - die aber innerhalb der vorher definierten Toleranz zu den echten Messdaten liegen. So müssen nur die - bei einem gut eingestellten Fertigungsprozess - wenigen groben "Ausreißer" gegenüber dem theoretischen Optimum gesichert werden.

Eine weitere Möglichkeit einer vorteilhaften Weiterbildung der Erfindung sieht die Verwendung von Differenzdaten zum Optimieren der Überwachungsparameter vor.

Vorteilhaft für die Unterscheidung zwischen Rausch- und Nutzsignal ist, dass für die erfindungsgemäße Datenkompression der Simulationsalgorithmus bzw. das Simulationsmodell einen hohen Detaillierungsgrad aufweisen muss und daher System und Prozess möglichst gut bekannt sein muss. Daraus lässt sich beispielsweise das träge Verhalten zentraler Komponenten bestimmen, welches dann für die Parametrierung entsprechender Bandpassfilter genutzt werden kann.

Wo dies unzureichend möglich ist, kann iterativ durch Hinzufügen von weiterer Sensorik sowohl im realen System als auch der Simulation eine zusätzliche Störgrößenerfassung erreicht werden, die eine bessere Unterscheidung zur eigentlichen Prozesswert-Erfassung ermöglicht.

Eine andere vorteilhafte Weiterbildung der Erfindung sieht einen Plausibilitätstest von Abweichungen zwischen den gemessenen und den synthetischen Prozessdaten vor. Dieser Test kann vorteilhaft in den Komprimierungs-, Überwachungs- oder Archivierungsprozess integriert sein. Hierbei können bevorzugt aus dem Model oder der Simulation bzw. dem Simulationsmodell zusätzlich auch die Grenzen der zu erwartenden Messwerte und deren Änderungsraten bestimmt werden. Bei Überschreitung dieser Grenzen eines erhaltenen Messwertes bzw. dessen Änderungsrate muss davon ausgegangen werden, dass entweder ein Sensor- oder Messwertverarbeitungs-Fehler vorliegt oder das Modell oder die Simulation das System bzw. den Prozess unzureichend abbilden. In beiden Fällen sollte bevorzugt das Simulations-Ergebnis verworfen werden so dass zunächst eine erfindungsgemäße Kompression auf dieser Basis nicht durchgeführt wird, ohne zuvor die Ursache für die zu große Abweichung zu beseitigen. Ein Beispiel wäre, dass bei bekanntem Energieeintrag die Temperatur in einem thermisch abgeschlossenen, trägen System nicht beliebig schnell ansteigen kann.

Eine andere vorteilhafte Weiterbildung sieht ein Clustern ähnlicher Prozessdaten bzw. Sensorwerte vor. Hierbei lassen sich Messdaten noch zusätzlich auf der Zeitachse komprimieren. Bevorzugt werden entlang der Zeitachse Cluster mit ähnlichen Sensorwerten gebildet. Bei diesen Prozessdaten wird der Wert jedes Clusters wird nur einmal gespeichert und anschließend nur eine Cluster-ID dem jeweiligen Zeitintervall zugeordnet. Diese Weiterbildung kann als eine spezielle Ausgestaltung und Anwendung des sogenannten LZ77-Algorithmus verstanden werden, der detaillierter beschrieben ist unter: https://de.wikipedia.org/wiki/LZ77.

Eine andere vorteilhafte Weiterbildung sieht ein Hashen der mittels Sensoren aufgenommenen Prozessdaten vor. Bei Anwendung der Datenkompression nach der Erfindung, zum Beispiel bei einer verlustfreien Deltakompression der Prozessdaten durch einen Simulationsvergleich werden mit einer geeigneten Hashfunktion Hashwerte über größere Blöcke von Prozessdaten berechnet, die nach der späteren Rekonstruktion der Daten die Konsistenz der rekonstruierten Blöcke bestätigen und somit Rekonstruktionsfehler (z.B. durch Datenverlust oder eine falsch konfigurierte Simulation) aufdecken. Ein solcher Hashwert belegt pro Datenblock nur wenige zusätzliche Bytes. Mittels eines "Verpackens" der Differenzdaten und einer Anreicherung dieser Archivdaten mit weiteren Metadaten kann die Zuverlässigkeit weiter erhöht werden. Die Archivdaten können insbesondere angereichert werden mit:
- einer eindeutigen Kennung des Simulationsalgorithmus,
- der Version des Simulationsalgorithmus,
- einem Hashwert über die ganzen Differenzdaten,
- einer digitalen Signatur,
- und den Prozessparametern der Simulation.

Diese mitgespeicherten Simulations-Metadaten stellen sicher, dass sich die gemessenen Prozessdaten mit Hilfe des bekannten Simulationsalgorithmus später binärgenau aus den Archivdaten, bzw. aus den Differenzdaten wiederherstellen lassen.

Dieser nach der Erfindung komprimierte Datensatz von Archivdaten lässt sich archivieren, kopieren, übertragen und als Bestandteil einer Komponente einer Fertigung (z.B. obligatorische Produktdokumentation) handhaben.

Eine vorteilhafte Weiterbildung der Erfindung sieht die Rekonstruktion der gemessenen Prozessdaten vor.

Die ursprünglich gemessenen und nach der Erfindung als Archivdaten komprimierten Prozessdaten lassen sich durch erneute Anwendung des Modells bzw. Simulation des Prozesses, oder Produktionsprozesses beim Empfänger/Anwender der Archivdaten reproduzieren. Im Einzelnen kann der Ablauf vorteilhaft vereinfacht dargestellt werden mit den Schritten:
a. Auffinden des Simulationsalgorithmus, mit dem die simulierten Prozessdaten vor dem Encodieren berechnet wurden; z.B. durch den Download des binären p-Codes der Simulation von einem Cloudspeicher.
b. Überprüfung der ID, der Version und/oder des Hashcodes des Simulationsalgorithmus.
c. Parametrierung der Simulation mit den identischen Parametern wie bei der Encodierung.
d. Ausführen des Modells bzw. Durchführen der Simulation zum Erzeugen der synthetischen Prozessdaten (z.B. Überwachungswerte, z.B. einer Fertigung) wie bei der Encodierung bzw. Komprimierung.
e. Addition der archivierten Differenzdaten zu den erneut berechneten synthetischen Prozessdaten und damit bitgenaue Decodierung/Wiederherstellung der ursprünglichen gemessenen (aber je nach Ausprägung der Erfindung vor der Differenzbildung geglätteten oder gefilterten) Prozessdaten.
f. Bevorzugt Prüfen der bitgenauen Datenreproduktion zum Beispiel mittels Vergleichs zweier Hashwerte. Hierbei kann auf Basis der wiederhergestellten Prozessdaten zur Absicherung gegen Fehler ein zweiter Hashwert berechnet werden, der mit dem archivierten ersten Hashwert übereinstimmen muss. So kann sichergestellt werden, dass die zweite Ausführung des Modells bzw. Simulation exakt die gleichen Binärdaten erzeugt hat wie die erste, und dass - bei verlustfreier Komprimierung - die rekonstruierten Werte mit den ursprünglich gemessenen Werten übereinstimmen. Bei verlustbehafteter Komprimierung ist es zumindest möglich die Ergebnisse nach dem verlustbehafteten der Komprimierung (zum Beispiel im Falle des Glättens der gemessenen Prozessdaten vor der Differenzbildung) bei der Erzeugung der Archivdaten mit den Ergebnissen nach der Addition bei der Wiederherstellung der Prozessdaten zu vergleichen, sofern bei der Komprimierung nach dem Verlust gehasht wurde.
g. Bei einer verlustbehafteten Ausprägung der Erfindung können vorteilhaft diejenigen rekonstruierten Prozessdaten markiert werden, die Kompressionsverluste erlitten haben.

Eine weitere vorteilhafte Weiterbildung der Erfindung sieht eine Ablage, Verwaltung, Bereitstellung und Versionskontrolle des Modells oder Simulationsalgorithmus sowie die Datenübertragung als webbasierte Dienste (z.B. in Mindsphere) vor.

Im Folgenden ist die Erfindung anhand eines speziellen Ausführungsbeispiels zur Verdeutlichung näher beschrieben. Es zeigt:

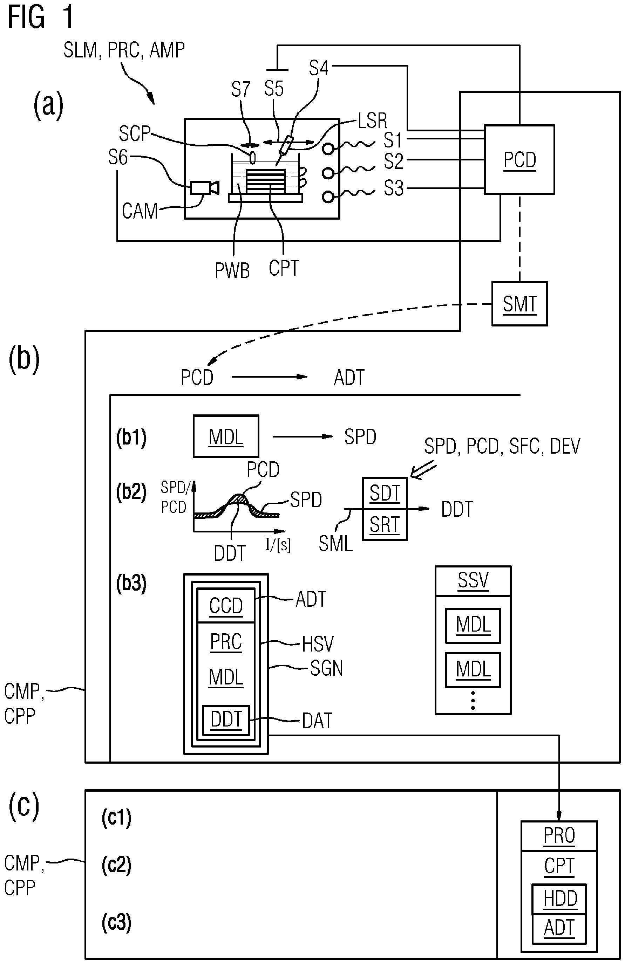

- Figur 1: eine schematische, vereinfachte Darstellung eines Ablaufschemas des Verfahrens nach der Erfindung mittels eines Systems mit einem Computer umfassend ein Computerprogrammprodukt.

Funktionsgleiche Elemente sind teilweise mit identischen Bezugszeichen versehen. Funktionsgleiche Bauelemente werden teilweise nicht in allen Figuren ausgewiesen und auch nicht zu jeder einzelnen Abbildung separat wiederholt erläutert. Es ist grundsätzlich davon auszugehen, dass diese Bauelemente in den unterschiedlichen Darstellungen jeweils eine im Wesentlichen gleiche Funktion aufweisen.

Figur 1 zeigt eine schematische, vereinfachte Darstellung eines Ablaufs eines erfindungsgemäßen Verfahrens zur Datenkompression von Messdaten MDT.

Das Verfahren umfasst zunächst die folgenden Schritte:
(a) Messen von Prozessdaten PCD eines Prozesses PRC,
(b) computer-implementiertes Verarbeiten der Prozessdaten PCD zu Archivdaten ADT.

Schritt (a) ist hierbei als Messen von Messdaten MDT eines Fertigungsverfahrens vereinfacht illustriert. Der dargestellte additive Fertigungsprozess AMP umfasst eine Überwachung des Fertigungsprozesses AMP mittels Messung von Prozessdaten PCD des Fertigungsprozesses AMP mittels verschiedener Sensoren S1, ..., S7. Beispielhaft kann es sich bei diesen Sensoren S1, ..., S7 um optische Sensoren CAM, Temperatursensoren, oder Bewegungsaufnehmer zur Aufnahme der Bewegung eines Lasers LSR für das selektive Laser Schmelzen SLM oder eines Schiebers SCR zur Ebnung eines Pulverbettes PWB handeln. Hier entstehen signifikante Mengen an Prozessdaten PCD, die nach dem Verfahren gemäß der Erfindung behandelt werden.

Optional findet ein Glätten SMT der Prozessdaten PCD statt, insbesondere, um ein überlagertes Rauschen in den Messwerten der Sensoren reduzieren. Hierbei werden die gemessenen Prozessdaten PCD bevorzugt vor dem Bestimmen von Differenzdaten DDT (in Schritt (b)) als eine Differenz zwischen den gemessenen Prozessdaten PCD und den synthetischen Prozessdaten SPD geglättet.

Das Verarbeiten (Schritt (b)) der Prozessdaten PCD zu Archivdaten ADT ist untergliedert in folgende weitere Schritte. Die Archivdaten ADT umfassen hierbei die Produkte dieser Schritte:
(b1) Bereitstellen eines computer-implementierten Modells MDL, dass die zu messenden Prozessdaten PCD als synthetische Prozessdaten SPD erzeugt,
(b2) computer-implementiertes Bestimmen von Differenzdaten DDT als eine Differenz zwischen den gemessenen Prozessdaten PCD und den synthetischen Prozessdaten SPD,
(b3) Erzeugen einer Zuordnung CCD des Modells MDL, der Differenzdaten DDT und dem Prozess PRC jeweils zueinander.

Ein Sampling SML der Differenzdaten DDT erfolgt mit einer bestimmten Samplingrate SRT und mit einer bestimmten Samplingtiefe SDT. Die Samplingtiefe SDT wird bevorzugt festlegt mittels der Schritte:
- Fehler-Abschätzen einer maximal zu erwartenden Abweichung DEV zwischen synthetischen Prozessdaten SPD und gemessenen Prozessdaten PCD als Fehlerabschätzung,
- Festlegen einer minimal erforderliche Amplitudenauflösung als Produkt eines Sicherheitsfaktors SFC mit der Fehlerabschätzung.

Optional kann ein Aufteilen der Abweichungen in relevante und irrelevante Abweichungen gegenüber der Simulation vorgesehen sein. Als relevant erkannte Abweichungen werden der Archivierung bzw. Differenzbildung (Schritt (b2): computer-implementiertes Bestimmen von Differenzdaten als eine Differenz zwischen den gemessenen Prozessdaten und den synthetischen Prozessdaten) unterzogen. Abweichungen, die nicht als relevant erachtet werden, werden vernachlässigt (zu Null gesetzt). Die Relevanz der Abweichung kann mittels eines Grenzwertes für den Betrag der Abweichung festgelegt sein, so dass bei Abweichungen unterhalb dieses Grenzwertes die Abweichung vernachlässigt wird und damit nur Abweichungen oberhalb des Grenzwertes Speicherplatz beanspruchen.

Die Archivdaten ADT werden anschließend computer-implementiert gespeichert und/oder übermittelt, bevorzugt umfassend die Teilschritte:
(c1) Speichern und/oder Übermitteln des Modells MDL,
(c2) Speichern und/oder Übermitteln der Differenzdaten DDT,
(c3) Speichern und/oder Übermitteln der Zuordnung CCD des Modells MDL, der Differenzdaten DDT und dem Prozess PRC jeweils zueinander.

Zur Verbesserung der Verlässlichkeit des Prozesses ist es sinnvoll, in dem Schritt (b3) und/oder Schritt (c3) den Archivdaten ADT oder Anteilen der Archivdaten ADT als zusätzlicher Bestandteil mittels einer Hashfunktion einen Hashwert HSV zuzuweisen und/oder, dass die Archivdaten ADT signiert (Signatur SGN) werden. Hierbei wird der Hashwert bevorzugt als zusätzlicher Bestandteil der Archivdaten ermittelt und behandelt, ggf. gespeichert oder/und übermittelt. Gleichsam kann eine Information darüber als Bestandteil der Archivdaten behandelt werden, welches Hash-Verfahren verwendet wurde.

Das Modell MDL kann getrennt von den Differenzdaten DDT - zum Beispiel auf einem Simulationsmodellserver SSV oder zusammen mit bevorzugt vorbestimmten Datenmengen DAT von Differenzdaten DDT gesichert werden.

Die Erfindung umfasst auch ein Computerprogrammprodukt CPP zur Durchführung der computerimplementierten Schritte ((b), (c)) des Verfahrens mittels mindestens eines Computers CMP.

Die bei dem Fertigungsverfahren entstehende Komponente CPT ergibt gemeinsam mit beispielsweise einem Datenträger HDD, beinhaltend Archivdaten ADT des Fertigungsprozesses dieser Komponente CPT, ein Produkt PRO, das insbesondere besonderen Dokumentationsanforderungen entspricht.

Diese Prozessdaten PCD sind nach einem Verfahren zur Datenkompression von Messdaten MDT gemäß der Erfindung zu Archivdaten ADT verarbeitet worden.

Aus diesem Ausführungsbeispiel wird nochmal deutlich, dass die Erfindung (in Form einer Prozesssimulation formalisiertes) Domänenwissen zur (verlustfreien oder verlustbehafteten) Datenkompression von Prozessdaten (insbesondere industrieller Fertigungsprozesse) durch eine (lokale) Reduktion der Informationsentropie (der gemessenen Prozessdaten).

Je besser ein gefertigtes Teil mit seiner Ausgangsspezifikation übereinstimmt, desto effizienter kann die simulationsgestützte Deltakompression die während der Produktion aufgenommenen Prozessdaten komprimieren.

Im Rahmen der "digitalen Zwillinge" werden vermehrt datentechnische Abbildungen realer Geräte, Anlagen und Prozesse erzeugt. Diese Zwillinge lassen sich in einer Art "Zweitnutzung" zur Kompression physisch gemessener Prozessdaten einsetzen. Zusätzlich können aus der Prozesssimulation heraus automatische Plausibilitätsuntersuchungen zur Prozess-/Systemüberwachung genutzt werden. Die Kompression von Prozessdaten vereinfacht deren Speicherung und den Transfer beispielsweise über mehrere Netzwerkschichten vom Shopfloor in die Cloud.

## Patentansprüche

1. Verfahren zur Datenkompression von Messdaten (MDT) umfassend die folgenden Schritte,
(a) Messen von Prozessdaten (PCD) eines Prozesses (PRC),
(b) computer-implementiertes Verarbeiten der Prozessdaten (PCD) zu Archivdaten (ADT),
**gekennzeichnet dadurch, dass** Schritt (b) die folgenden weiteren Schritte umfasst:
(b1) Bereitstellen eines computer-implementierten Modells (MDL), das die zu messenden Prozessdaten (PCD) als synthetische Prozessdaten (SPD) erzeugt,
(b2) computer-implementiertes Bestimmen von Differenzdaten (DDT) als eine Differenz zwischen Prozessdaten (PCD) oder einer auf den gemessenen Prozessdaten (PCD) basierenden Größe und synthetischen Prozessdaten (SPD) oder einer entsprechenden Größe basierend auf den synthetischen Prozessdaten (SPD), wobei die Archivdaten (ADT) diese Differenzdaten (DDT) umfassen,
(b3) Erzeugen einer Zuordnung (CCD) des Modells (MDL), der Differenzdaten (DDT) und des Prozesses (PRC) jeweils zueinander, wobei die Archivdaten (ADT) die Zuordnung (CCD) umfassen.

2. Verfahren nach Anspruch 1, wobei das Verfahren einen weiteren Schritt (c) umfasst:
(c) computer-implementiertes Speichern und/oder Übermitteln der Archivdaten (ADT), umfassend die Teilschritte:
(c1) Speichern und/oder Übermitteln des Modells (MDL),
(c2) Speichern und/oder Übermitteln der Differenzdaten (DDT),
(c3) Speichern und/oder Übermitteln der Zuordnung (CCD) des Modells (MDL), der Differenzdaten (DDT) und dem Prozess (PRC) jeweils zueinander.

3. Verfahren nach Anspruch 1 oder 2, wobei die Differenzdaten (DDT) mit einer bestimmten Samplingtiefe (SDT) codiert werden, wobei die Samplingtiefe (SDT) festlegt wird mittels der Schritte:
- Fehler-Abschätzen einer maximal zu erwartenden Abweichung zwischen synthetischen Prozessdaten (SPD) und gemessenen Prozessdaten (PCD) als Fehlerabschätzung,
- Festlegen einer minimal erforderliche Amplitudenauflösung als Produkt eines Sicherheitsfaktors mit der Fehlerabschätzung.

4. Verfahren nach Anspruch 1, 2 oder 3, wobei die gemessenen Prozessdaten (PCD) vor dem Bestimmen von Differenzdaten (DDT) geglättet werden, so dass die Differenzdaten (DDT) als eine Differenz zwischen den geglätteten gemessenen Prozessdaten (PCD) und der entsprechenden Größe basierend auf den synthetischen Prozessdaten (SPD) bestimmt werden.

5. Verfahren nach Anspruch 2, 3 oder 4, wobei Schritt (b3) nach Anspruch 1 und/oder Schritt (c3) nach Anspruch 2 umfasst, den Archivdaten (ADT) oder Anteilen der Archivdaten (ADT) als zusätzlichen Bestandteil mittels einer Hashfunktion einen Hashwert zuzuweisen und/oder, dass die Archivdaten (ADT) signiert werden.

6. Verfahren nach Anspruch 2, 3, 4 oder 5, wobei eine Speicherung nach Anspruch 2 vorsieht, dass das Modell (MDL) zusammen mit vorbestimmten Datenmengen von Differenzdaten (DDT) gesichert wird.

7. Fertigungsverfahren umfassend einen Fertigungsprozess (AMP), insbesondere additives Fertigungsverfahren, mit einer Überwachung des Fertigungsprozesses (AMP) mittels Messung von Prozessdaten (PCD) des Fertigungsprozesses (AMP), wobei die gemessenen Prozessdaten (PCD) nach dem Verfahren nach mindestens einer der vorhergehenden Ansprüche behandelt werden.

8. Computerprogrammprodukt (CPP) zur Durchführung der computerimplementierten Schritte eines Verfahrens gemäß mindestens einem der vorhergehenden Ansprüche mittels mindestens eines Computers (CMP).

9. Produkt umfassend eine Komponente (CPT), die nach einem Fertigungsverfahren gemäß Anspruch 7 gefertigt wurde und einen Datenträger (HDD) beinhaltend Prozessdaten (PCD) des Fertigungsprozesses dieser Komponente,
wobei die Prozessdaten (PCD) nach einem Verfahren zur Datenkompression von Messdaten (MDT) gemäß mindestens einem der vorhergehenden Ansprüche 1 bis 6 zu Archivdaten (ADT) verarbeitet worden sind und wobei die Archivdaten (ADT) gespeichert nach Anspruch 2 auf dem Datenträger (HDD) vorliegen.
